# EUROPEAN PATENT APPLICATION

(11) **EP 0 573 823 A2**
(43) Date of publication of application: **15.12.1993**
(21) Application number: 93108146.7
(22) Date of filing: 19.05.1993
(51) Int. Cl.: H01L 21/205, H01L 21/336

(54) **Deposition method for depositing a semiconductor thin film and manufacturing method of thin film transistors with use of the deposition method**

(30) Priority: 20.05.1992 JP 127166/92
(71) Applicant: MATSUSHITA ELECTRIC INDUSTRIAL CO., LTD., Kadoma-shi, Osaka 571 (JP)
(72) Inventor: Yoshioka, Tatsuo, Hirakata-shi, Osaka (JP); Kawamura, Tetsuya, Hirakata-shi, Osaka (JP); Sano, Hiroshi, Hirakata-shi, Osaka (JP); Furuta, Mamoru, Hirakata-shi, Osaka (JP); Miyata, Yutaka, Ikoma-shi, Nara (JP)
(74) Representative: Eisenführ, Speiser & Partner

(57) **Abstract**

A deposition method for depositing an amorphous silicon thin film on a protection layer of silicon nitride (5) formed on an amorphous silicon layer (4) which is deposited on a substrate (1) wherein, after the protection layer (5) is patterned into a predetermined configuration in ambient, the protection layer (5) is irradiated by hydrogen plasma in a vacuum chamber and, successively, an amorphous silicon thin film (7) is deposited on the substrate (1) and the protection layer (5) in the vacuum chamber.

This deposition method is applied to a manufacturing method for thin film transistors suitably.

## Description

### BACKGROUND OF THE INVENTION

### [Field of the invention]

The present invention relates to a deposition method for depositing a semiconductor thin film on an insulation film and a manufacturing method of thin film transistors using the deposition method.

### [Description of the prior art]

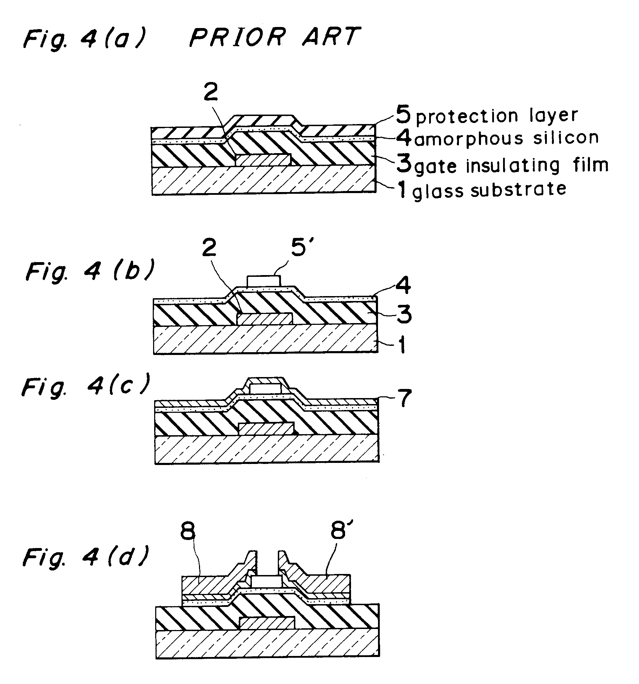

In a manufacturing process of thin film transistors, as shown in Fig. 4(a), gate insulating film 3, amorphous silicon 4 and silicon nitride 5 are deposited successively on a glass substrate 1 with a gate electrode 2 in a vacuum chamber (not shown) and the substrate 1 is taken out from the vacuum chamber to subject the silicon nitride 5 to patterning for forming a protection layer 5', as shown in Fig. 4(b).

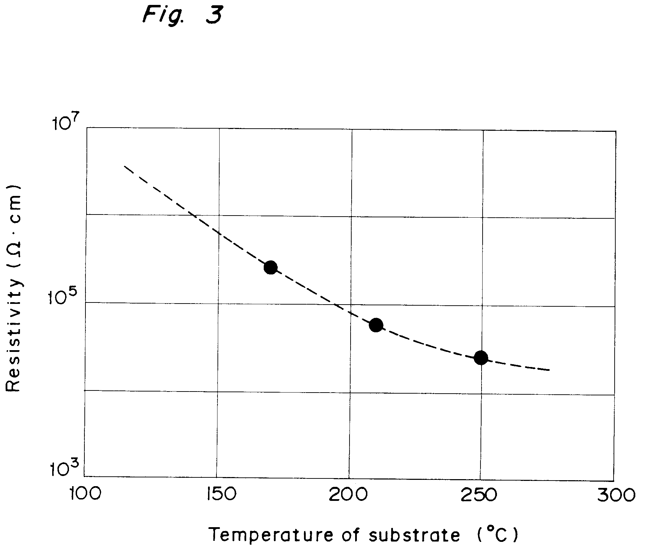

Thereafter, the substrate 1 is again put into the vacuum chamber and n⁺ amorphous silicon 7 is deposited on the amorphous silicon layer 4 including the protection layer 5' as shown in Fig. 4(c). Then, the n⁺ amorphous silicon layer 7 is separated on the protection layer 5' and, source and drain electrodes 8 and 8' are formed on the separated silicon layer 7. This n⁺ amorphous silicon layer 7 is introduced to reduce a junction resistance between the source and drain electrodes 8 and 8' and the semiconductor layer. The junction resistance is dependent on a temperature of the substrate 1 at which the n⁺ amorphous silicon layer 7 is deposited. Fig. 3 shows a relation between the junction resistance and the temperature of the substrate. As is apparent from Fig. 3, it is desirable to keep the temperature of the substrate at a temperature higher than 200 °C in order to realize a relatively low junction resistivity.

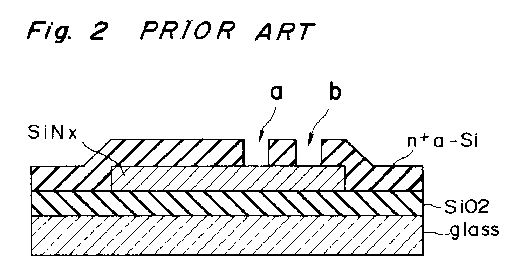

However, as indicated by arrows a and b in Fig. 2 schematically, peeling of n⁺a-Si is apt to cause when n⁺a-Si is deposited on the silicon nitride layer while heating the substrate at a temperature higher than 200 °C, for example 250 °C. The deposition of n⁺a-Si was made using parallel plate electrode type plasma CVD under conditions as follows. Power: 0.04 W/cm², Pressure: 0.5 Torr, Gas flow ratio PH₃/SiH₄: 0.5%, Temperature of substrate: 250 °C. Due to this, the substrate has to be kept at a temperature lower than 200 °C, for example 170 °C, upon depositing the n⁺a-Si layer. This raises the resistivity by one or more order when compared with that obtained at 200 °C or more, resulting in a poor operability of the thin film transistor.

### SUNMARY OF THE INVENTION

An object of the present invention is to provide a method for depositing a semiconductor film on an insulating film at a high temperature without causing peeling of the semiconductor film.

Another object of the present invention is to provide a manufacturing method capable of producing thin film transistors with a low junction resistance.

In order to achieve these objects, according to the present invention, the silicon nitride film deposited on the substrate is irradiated with hydrogen plasma in a vacuum chamber before depositing n⁺ amorphous silicon. This enables to deposit n⁺ amorphous silicon on the silicon nitride film while heating the substrate at a temperature higher than 200 °C or more.

Thus, according to the present invention, thin film transistors with excellent electric properties can be obtained.

### BRIEF DESCRIPTION OF THE DRAWINGS

These and other objects and features of the present invention will become clear from the following description taken in conjunction with the preferred embodiments thereof with reference to the accompanying drawings throughout which like parts are designated by like reference numerals, and in which:
Figs. 1(a), 1(b), 1(c) and 1(d) show a flow chart of a manufacturing method of thin film transistors according to the present invention;
Fig. 2 is a schematic sectional view for showing peeling of n⁺a-Si from silicon nitride layer when deposited while heating the substrate at 250 °C;
Fig. 3 is a graph showing characteristics of the junction resistivity dependent on the temperature of the substrate; and
Figs. 4(a), 4(b), 4(c) and 4(d) show a flow chart of a conventional manufacturing method of thin film transistors.

### DETAILED DESCRIPTION OF THE PREFERRED EMBODIMENTS

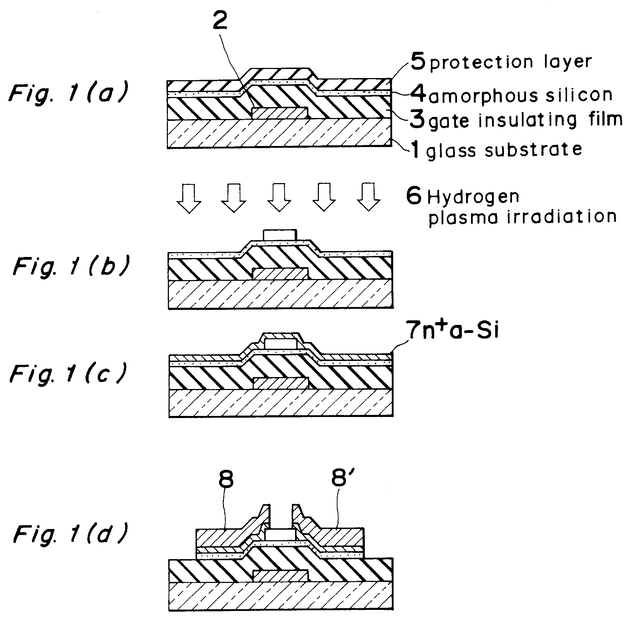

Referring to Figs. 1(a), 1(b), 1(c) and 1(d), a manufacturing method of thin film transistors using a depositing method of thin films according to the present invention will be explained hereinafter.

At first, as shown in Fig. 1(a), a gate electrode 2 having a predetermined pattern is formed on a glass substrate 1 and, on the glass substrate 1, gate insulating film 3, semiconductor layer 4 of amorphous silicon, protection layer 5 of silicon nitride are deposited in a vacuum chamber (not shown) successively according to a known deposition method such as PCVD (Plasma Chemical Vapour Deposition). The gate electrode 2 and the gate insulating film 3 can be single layer or multi-layer.

Then, the substrate 1 is taken out from the vacuum chamber to ambient and the protection layer 5 is patterned to a predetermined configuration after subjecting the substrate to a cleaning process.

Thereafter, the substrate 1 with the patterned protection layer 5' is brought into the vacuum chamber again and, as shown in Fig. 1(b), the semiconductor layer 4 is irradiated by hydrogen plasma beam 6 which is generated by a pair of parallel plate electrodes (not shown). In this plasma processing, conditions are settable as follows;

| | |
|---|---|
| Temperature of substrate: | ambient temperature to 300 °C. |
| Flow rate of H² gas: | 10 to 1000 sccm, |
| Pressure: | 0.1 to 3 Torr, |
| RF Power density: | 0.01 to 1 W/cm², |
| Processing time: | 10 sec. to 60 min. |

As a gas suitable for the hydrogen plasma processing, inactive gas such as nitrogen, argon, helium or the like can be mixed into H² gas. After the hydrogen plasma processing, n⁺ amorphous silicon thin film 7 is deposited in the vacuum chamber without exposing the substrate to ambient, as shown in Fig. 1(c).

Deposition conditions are as follows;

| | |
|---|---|
| Temperature of Substrate: | 100 to 300 °C, |
| Gas flow rate of SiH₄: | 10 to 500 sccm, |
| Gas flow rate of PH₃: | 10 to 500 sccm, |
| (diluted by H₂ to a density of 0.1 to 2 %), | |
| Gas flow rate of H₂ | 0 to 500 sccm, |
| Pressure: | 0.1 to 2 Torr, |
| RF power density: | 0.01 to 0.5 W/cm², |
| Thickness of deposition: | 100 to 1000 Å. |

Finally, source and drain electrodes 8 and 8' are formed as shown in Fig. 1(d), and, thereby, a thin film transistor is manufactured.

Inventors of the present invention confirmed that no peelings were observed when deposition tests of n⁺a-Si were repeated while keeping the temperature of substrate at 200 °C or more.

The n⁺ amorphous silicon thin film deposited while heating the substrate at a temperature higher than 200 °C has a resistance lower than that deposited at a temperature lower than 200 °C and, accordingly, the junction resistance between the source or drain electrode and the semiconductor layer can be reduced reasonably. This enables to fabricate thin film transistors having a higher mobility than that of the conventional ones. Further, the yield of thin film transistors is highly enhanced because peeling of the n⁺ amorphous silicon thin film from the protection layer of silicon nitride can be prevented perfectly.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

## Claims

1. A deposition method for depositing an amorphous silicon thin film on a substrate having a layer with a predetermined configuration thereon which is made of a silicon material comprising steps of
irradiating said layer on said substrate with hydrogen plasma in a vacuum chamber and
depositing amorphous silicon on said substrate including said layer in the vacuum chamber successively to the foregoing step without exposing the substrate to ambient.

2. A manufacturing method for thin film transistors comprising steps of
forming a gate electrode having a predetermined configuration on a transparent substrate,
depositing insulating layer, first semiconductor layer and protection layer on said transparent substrate and gate electrode successively,
patterning said protection layer into a predetermined configuration,
irradiating said protection layer with hydrogen plasma in a vacuum chamber, and
depositing second semiconductor layer containing at least one impurity on said substrate and protection layer.

3. The manufacturing method according to claim 2 wherein said first and second semiconductor layers are amorphous silicon layers, said protection layer is a silicon nitride layer and at least one impurity is phosphorus.
